# EUROPÄISCHE PATENTSCHRIFT

(11) **EP 3 012 220 B1**
(45) Veröffentlichungstag und Bekanntmachung des Hinweises auf die Patenterteilung: **28.06.2017**
(21) Anmeldenummer: 15185827.1
(22) Anmeldetag: 18.09.2015
(51) Int. Cl.: B81C 1/00, B81C 3/00

(54) **VERFAHREN ZUM VERBINDEN ZWEIER SUBSTRATE, ENTSPRECHENDE ANORDNUNG ZWEIER SUBSTRATE UND ENTSPRECHENDES SUBSTRAT**
METHOD OF CONNECTING TWO SUBSTRATES, CORRESPONDING ASSEMBLY OF TWO SUBSTRATES AND CORRESPONDING SUBSTRATE
PROCEDE DE LIAISON DE DEUX SUBSTRATS, SYSTEME CORRESPONDANT DE DEUX SUBSTRATS ET SUBSTRAT CORRESPONDANT

(30) Priorität: 24.10.2014 DE 102014221618
(43) Veröffentlichungstag der Anmeldung: 27.04.2016
(73) Patentinhaber: ROBERT BOSCH GMBH, 70442 Stuttgart (DE)
(72) Erfinder: Frey, Peter, 75242 Schellbronn (DE); Schelling, Christoph, 70597 Stuttgart (DE); Borowsky, David, 87435 Kempten (Allgaeu) (DE)

(56) Entgegenhaltungen:
- EP-A1- 2 157 605
- US-A1- 2004 100 164

## Beschreibung

Die Erfindung betrifft ein Verfahren zum Verbinden zweier Substrate, eine entsprechende Anordnung zweier Substrate und ein entsprechendes Substrat.

### Stand der Technik

Obwohl auch beliebige mikromechanische Substrate anwendbar sind, werden die vorliegende Erfindung und die ihr zugrundeliegende Problematik anhand von MEMS-Wafersubstraten auf Siliziumbasis erläutert.

Im Stand der Technik sind für das Bonden bzw. Verbinden zweier Substrate, beispielsweise Wafersubstrate, zahlreiche Bondverfahren bekannt. Günstig für das Bonden sind insbesondere solche Verfahren, die über eine flüssige Phase beim Bondvorgang ablaufen, was einen Topografieausgleich ermöglicht. Generell kann man zwischen eutektischen und SLID(Solid-Liquid Interdiffusion)-Bondmaterialsystemen und -verfahren unterscheiden.

Diese Verfahren sind insbesondere für das Verbinden von ASIC-Substraten weitverbreitet. Vor dem Bonden wird dort eine Nassreinigung der Bondflächen zur Entfernung von Oxiden auf den Bondoberflächen durchgeführt. Für MEMS-Strukturen ist dies in der Regel nicht möglich, da freigestellte Strukturen beim Trocknen verkleben würden. Andererseits ist auch eine trockene Dampf- oder Plasma-Reinigung für MEMS-Strukturen oft nicht möglich, weil z.B. die Bondmetallisierung durch das reduzierende Reagens verschleppt werden kann (beispielsweise Cu-Verschleppung durch Ameisensäuredampf).

Im MEMS-Prozessfluss wird die Bondmetallisierung in der Regel vor dem Freistellen der mikromechanischen Struktur entweder mittels galvanischer Nassprozesse in eine Lackmaske strukturiert aufgewachsen oder ganzflächig aufgebracht und nachfolgend strukturiert. Im Anschluss daran muss in vielen Fällen die Bondoberfläche noch während des Ätzvorganges zum Freistellen der Strukturen durch eine Lackschicht geschützt werden.

Vor dem Bonden müssen diese Lacke trocken entfernt werden, was normalerweise mit einem Sauerstoffplasma erfolgt. Bei diesem Lackentfernungsschritt kann je nach Bondmetallsystem die Oberfläche der Bondmetallisierung oxidiert werden, wobei sich mehrere hundert Nanometer dicke Oxidschichten ausbilden können, die teilweise delaminieren und sich als Partikel ablösen. Oxidschichten an den Bondgrenzflächen behindern die notwendige Interdiffusion der Bondmaterialien der beiden zu verbindenden Bondoberflächen und führen so zu einer verminderten Bondhaftung und/oder einer elektrisch isolierenden bzw. hochohmigen Bondverbindung.

Aus der US 2012/0094435 A1 ist ein eutektisches Bondverfahren mit Al-Ge und aus der DE 20 2006 006 610 U1 ist ein SLID-Bondverfahren mit Cu-CuSn für das Verbinden zweier Substrate mit Flüssigphasen bekannt.

Aus der EP 2157605 A1 sind eine Elektronikkomponentenvorrichtung und ein Verfahren zur Herstellung derselben bekannt. Das Verfahren beschreibt einen Wärmeverbindungsprozess, welcher dazu geeignet ist, eine Zeit zur Verbindung von Leiterfilmen, welche Metalle mit hohem Schmelzpunkt umfassen, zu verkürzen, indem ein Metall mit niedrigem Schmelzpunkt für die Verbindung der Leiterfilme verwendet wird. Die Leiterfilme sind in einem Verbindungsbereich miteinander verbunden. Im Verbindungsbereich verbleibt ein Teil der Schicht mit hohem Schmelzpunkt.

Aus US 20040100164 A1 ist ein Herstellungsverfahren für eine elektronische Vorrichtung bekannt, wobei für das Bonding Zinn (Sn) verwendet wird.

### Offenbarung der Erfindung

Die Erfindung schafft ein Verfahren zum Verbinden zweier Substrate nach Anspruch 1, eine entsprechende Anordnung zweier Substrate nach Anspruch 10 und ein entsprechendes Substrat nach Anspruch 13.

Bevorzugte Weiterbildungen sind Gegenstand der jeweiligen Unteransprüche.

### Vorteile der Erfindung

Das erfindungsgemäße Verfahren zum Verbinden zweier Substrate vermeidet/vermindert die Oxidation der Bondmetallisierungsoberfläche, insbesondere derjenigen von MEMS-Substraten, durch eine Oxidationsschutzschicht.

Erfindungsgemäß wird auf dem ersten Substrat, beispielsweise einem MEMS-Substrat, unterhalb der beispielsweise mehrere Mikrometer dicken Bondmaterialschicht eine Diffusionsbarriereschicht und über der Bondmaterialschicht eine typischerweise 0,5 µm dünne Oxidationsschutzschicht aus einem oxidationsresistenten Material, wie z.B. Gold, Platin, Palladium, Ruthenium, Molybdän, Wolfram usw., abgeschieden. Beispielsweise kann das zweite Substrat ein Kappenwafersubstrat oder ASIC-Substrat sein.

Da die zuvor genannten in Frage kommenden Materialien der Oxidationsschutzschicht Edelmetalle sind, sind diese zu teuer für eine direkte Verwendung als dicke Bondschichten zur Abstandseinstellung zwischen den beiden Substraten.

Die erfindungsgemäße Oxidationsschutzschicht kann wesentlich dünner gestaltet werden als die eigentliche Bondmaterialschicht. Die Oxidationsschutzschicht diffundiert idealerweise unterhalb der Bondtemperatur zumindest teilweise in das darunterliegende Bondmaterial ein und legt so die Oberfläche des eigentlichen Bondmaterials frei und/oder bildet selbst mit der gegenüberliegenden Seite eine flüssige Phase aus. Die Schichtdickenverhältnisse sind dabei idealerweise so gewählt, dass das Material der Oxidationsschutzschicht nach dem Bonden eine Beimischung unterhalb von 20 %, vorzugsweise unterhalb von 10 %, gemittelt über die gesamte Bondverbindung darstellt.

Zum Eindiffundieren des Materials der Oxidationsschutzschicht sieht das erfindungsgemäße Verfahren ein Aufheizen wenigstens des ersten Substrats in vom zweiten Substrat getrennten Zustand auf eine erste Temperatur, beispielsweise oberhalb von 150-200°C, vor, sodass sich ein modifizierter erster Bondbereich ausbilden kann, in dem das Material der Oxidationsschutzschicht beigemischt ist. Dieser Diffusionsschritt kann entweder zuvor in einem eigens dafür vorgesehenen Tool oder während des Bondprozesses im Bondtool selbst erfolgen.

Erst in einem anschließenden Prozessschritt wird im Bondtool der Zwischenbereich zwischen den Substraten auf den gewünschten Zieldruck gebracht, die beiden zueinander ausgerichteten Substrate im Bondtool aufeinandergepresst und auf eine zweite Temperatur, die eigentliche Bondtemperatur, weiter aufgeheizt. Diese liegt über der Temperatur, bei der sich eine flüssige Bondphase bildet (typischerweise 240 bis 300°C) und die Ausbildung des Bondverbindungsbereichs stattfindet. Durch weiteres Halten bzw. Erhöhen der Temperatur kann das Bondmaterial vollständig durchreagieren und die Entstehung einer mechanisch und thermodynamisch stabilen intermetallischen Phase (beispielsweise Cu3Sn) begünstigt werden.

Die vorliegende Erfindung kann in verschiedenen Anwendungsbereichen eingesetzt werden, in denen eine mechanisch stabile Verbindung und/oder eine hermetische Dichtung und/oder ein elektrischer Kontakt zwischen mindestens zwei Wafern oder Chips oder einem Wafer und einem Chip geschaffen werden muss, wobei eine bevorzugte Anwendung MEMS-Wafer sind. Derartige MEMS-Substrate finden Anwendung bei der Herstellung von Infrarot-Sensorarrays, Beschleunigungssensoren, Drehratensensoren, Drucksensoren usw.

Gemäß einer bevorzugten Weiterbildung wird das zweite Substrat vor dem Zusammenbringen nasschemisch zur Oxidentfernung gereinigt. Dies vereinfacht den Prozess, wenn das zweite Substrat entsprechend robust ist, z. B. ein ASIC-Substrat.

Gemäß einer weiteren bevorzugten Weiterbildung werden das erste und das zweite Substrat gemeinsam, jedoch voneinander beabstandet in einem Bondtool auf die erste Temperatur aufgeheizt. Dies erspart Prozesszeit.

Gemäß einer weiteren bevorzugten Weiterbildung weist das Material der ersten Oxidationsschutzschicht einen Anteil von unterhalb 20 Atom%, bevorzugt von unterhalb 10 Atom%, gemittelt über den Bondverbindungsbereich auf. So läßt sich der erwünschte Effekt kostengünstig erzielen.

Gemäß einer weiteren bevorzugten Weiterbildung weist das Material der ersten oder zweiten Diffusionsbarrierenschicht Titannitrid, Tantalnitrid oder Titan-Wolfram auf. Diese Materialien bilden eine gute Diffusionsbarriere gegenüber den Bondmaterialien.

Gemäß einer weiteren bevorzugten Weiterbildung ist das Material des ersten Bondbereichs Aluminium und des zweiten Bondbereichs Germanium oder Silizium.

Gemäß einer weiteren bevorzugten Weiterbildung ist das Material des ersten Bondbereichs Kupfer und des zweiten Bondbereichs in zwei Lagen geschichtetes Kupfer/Zinn.

Gemäß einer weiteren bevorzugten Weiterbildung ist das Material des ersten Bondbereichs Nickel und des zweiten Bondbereichs in zwei Lagen geschichtetes Nickel/Zinn.

Gemäß einer weiteren bevorzugten Weiterbildung weist das Material der ersten Oxidationsschutzschicht Gold, Platin, Palladium, Ruthenium, Molybdän oder Wolfram auf. Durch geringe Mengen dieser Materialien lässt sich ein wirksamer Oxidationsschutz bilden.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1 a)-e): schematische senkrechte Querschnittsansichten zum Erläutern eines Verfahrens zum Verbinden zweier Substrate und einer entsprechenden Anordnung zweier Substrate gemäß einer Ausführungsform der vorliegenden Erfindung, und zwar Fig. 1 a) und b) vor dem Zusammenbringen und Fig. 1c) bis e) nach dem Zusammenbringen;
- Fig. 2: die Abhängigkeit der Temperatur T (Kurve K1) und des Abstandes A (Kurve K2) von der Zeit t zum Erläutern des Verfahrens zum Verbinden zweier Substrate und einer entsprechenden Anordnung zweier Substrate gemäß der Ausführungsform nach Fig. 1a)-e); und
- Fig. 3: eine schematische ebene Darstellung der Verbindungsebene eines MEMS-Substrats zur Verwendung des beschriebenen Verfahrens zum Verbinden zweier Substrate gemäß einer weiteren Ausführungsform der vorliegenden Erfindung.

### Ausführungsformen der Erfindung

In den Figuren bezeichnen gleiche Bezugszeichen gleiche bzw. funktionsgleiche Elemente.

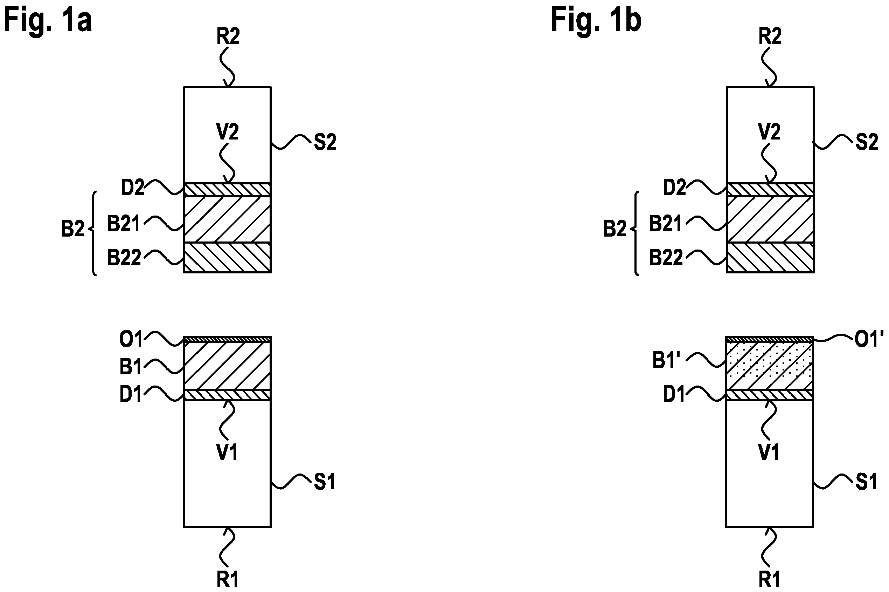

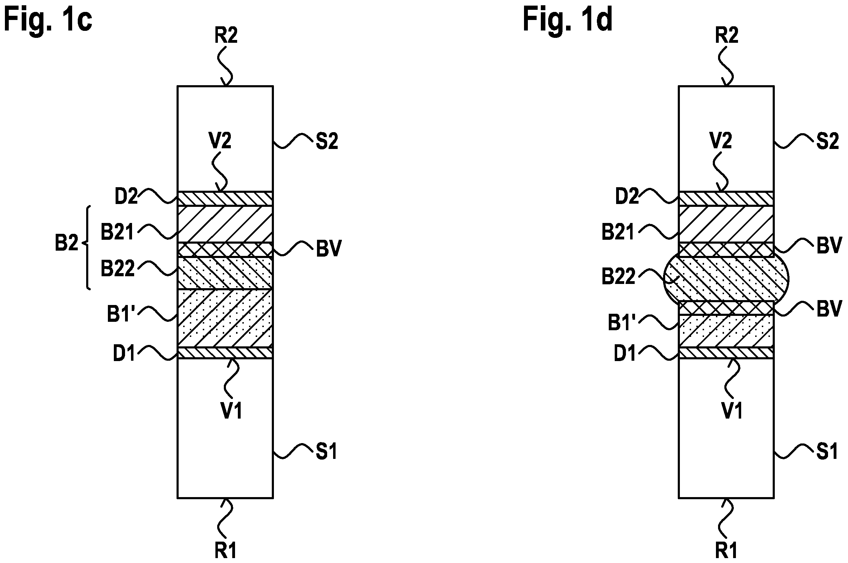

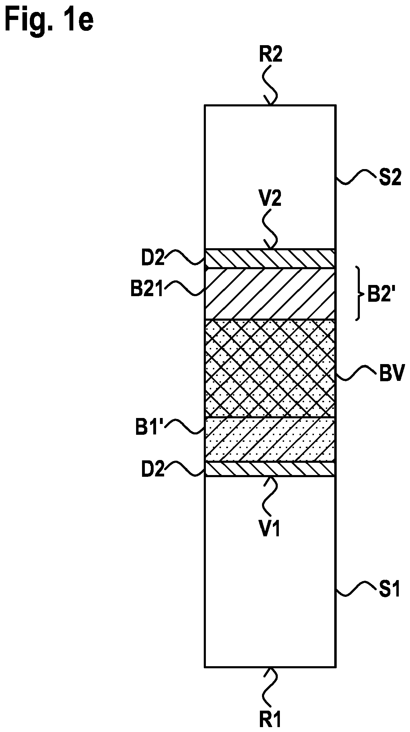

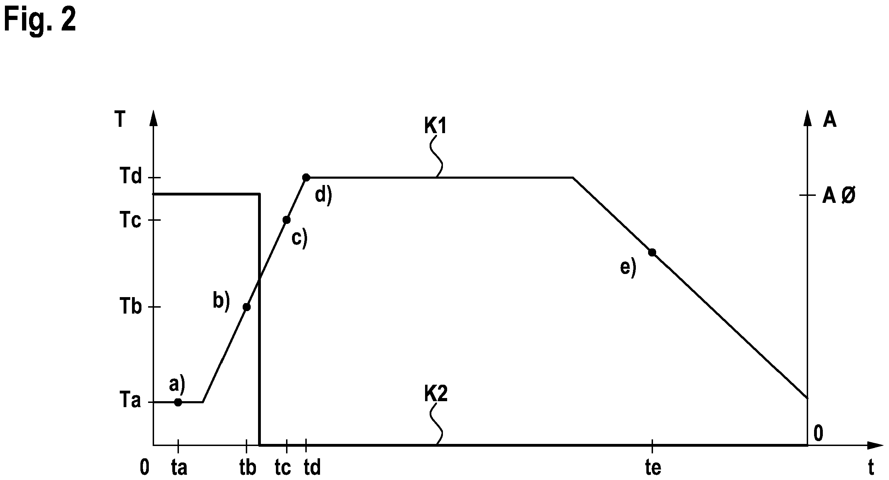

Fig. 1a)-e) sind schematische senkrechte Querschnittsansichten zum Erläutern eines Verfahrens zum Verbinden zweier Substrate und einer entsprechenden Anordnung zweier Substrate gemäß einer Ausführungsform der vorliegenden Erfindung, und zwar Fig. 1a) und b) vor dem Zusammenbringen und Fig. 1c) bis e) nach dem Zusammenbringen, und Fig. 2 zeigt die entsprechende Abhängigkeit der Temperatur T (Kurve K1) und des Abstandes A (Kurve K2) von der Zeit t zum Erläutern des Verfahrens zum Verbinden zweier Substrate gemäß Fig. 1a)-e).

In Fig. 1a) bis 1e) bezeichnet Bezugszeichen S1 ein erstes Substrat, im vorliegenden Beispiel ein MEMS-Wafersubstrat, und Bezugszeichen S2 ein zweites Substrat, im vorliegenden Beispiel ein Kappenwafersubstrat.

Das erste Substrat S1 weist eine erste Vorderseite V1 und eine erste Rückseite R1 auf. Das zweite Substrat S2 weist eine zweite Vorderseite V2 und eine zweite Rückseite R2 auf.

Aus Gründen der Vereinfachung der Darstellung ist in Fig. 1a) bis e) nur derjenige Bereich der ersten Vorderseite V1 und der zweiten Vorderseite V2 dargestellt, in dem der Verbindungsprozess bzw. Bondprozess stattfindet.

Auf die erste Vorderseite V1 wird eine erste Diffusionsbarriereschicht D1 und auf die zweite Vorderseite V2 wird eine zweite Diffusionsbarriereschicht D2 aufgetragen, beispielsweise aus TiW (Titan-Wolfram) mit einer Schichtdicke von jeweils 50 nm.

Ein erster Bondbereich B1 auf der ersten Vorderseite mit einer Bondmaterialschicht B1 aus Cu (Kupfer) in einer Schichtdicke von 5 µm wird auf die erste Diffusions-barriereschicht D1 aufgebracht. Ein zweiter Bondbereich B2 auf der zweiten Vorderseite mit einer zweiten Bondmaterialschicht B21 aus Cu (Kupfer) mit einer Schichtdicke von 5 µm und einer dritten Bondmaterialschicht B22 aus Zinn in einer Schichtdicke von 2-3 µm wird auf der zweiten Diffusionsbarriereschicht D2 aufgebracht. Beim ersten Substrat S1 kann die erste Bondmaterialschicht B1 beispielsweise in einer Leiterbahnebene realisiert sein, also Teil der Metallisierung des Schaltungssubstrats sein.

Schließlich wird auf den ersten Bondbereich B1 eine Oxidationsschutzschicht O1 aus einem oxidationsresistenten Material aufgebracht, im vorliegenden Fall eine Goldschicht mit einer Schichtdicke von 300 nm. Weitere in Frage kommende Materialien sind u.a. Platin, Palladium, Ruthenium, Molybdän, Wolfram usw.

Weiter unter gleichzeitiger Bezugnahme auf Fig. 2 ist der Zustand gemäß Fig. 1a) der Ausgangszustand vor dem Bondverfahren.

Die Temperatur Ta zum Zeitpunkt ta ist Raumtemperatur. Anschließend findet gemäß Fig. 1b) ein Aufheizen wenigstens des ersten Substrats S1 im vom zweiten Substrat S2 beabstandeten Zustand auf eine erste Temperatur Tb zu einem ersten Zeitpunkt tb statt, bei der die erste Oxidationsschutzschicht O1 in den ersten Bondbereich B1 zumindest teilweise interdiffundiert (angedeutet durch eine Punktierung), um so einen modifizierten ersten Bondbereich B1' zu bilden. Über den gesamten Bondverbindungsbereich gemittelt ergibt sich beispielsweise eine Konzentration des Oxidationsschutzmaterials unterhalb von 20 oder vorzugsweise unterhalb von 10 Atomprozent. Ein möglicher Restbereich O1' der Oxidationsschutzschicht O1 beinhaltet eine gewisse Menge eindiffundiertes Kupfer.

Das Aufheizen des ersten Substrats S2 auf die erste Temperatur Tb erfolgt zwar im vom zweiten Substrat S2 beabstandeten Zustand, jedoch vorzugsweise gemeinsam in einem entsprechenden Bondtool, um Zeit zu sparen. Dabei kann optional ein reduzierendes Gas, beispielsweise Formiergas oder ein anderes gewünschtes Gas, in die Bondkammer eingelassen werden.

Nach Aufheizen auf die erste Temperatur (Kontakttemperatur) Tb kann die Bondkammer auf einen gewünschten Zieldruck evakuiert werden, bevor die beiden Substrate S1, S2 zusammengebracht werden, wobei sich gemäß Fig. 2 der Abstand A von einem Ausgangsabstand A0 auf 0 verringert. Dabei können die Substrate S1, S2 unter Anwenden eines externen mechanischen Drucks aufeinandergepresst werden, wobei die Ausbildung eines Bondverbindungsbereiches BV beginnt.

Anschließend erfolgt ein weiteres Aufheizen der zusammengebrachten Substrate S1, S2 auf eine zweite Temperatur Tc zum Zeitpunkt tc, bei der die niedrigschmelzendste Komponente des zweiten Bondbereichs B2 aufschmilzt, nämlich vorliegend die dritte Bondmaterialschicht B22 aus Zinn. Vorzugsweise übersteigt dieses Aufheizen eine Temperatur von größenordnungsmäßig 400°C nicht, um sicherzustellen, dass keine weiteren Komponenten in einem der Substrate in Mitleidenschaft gezogen werden.

Der aufgeschmolzene Zustand der dritten Bondmaterialschicht B22 ist in Fig. 1d) dargestellt, wobei sich ein Bondverbindungsbereich BV aus einer Cu-Sn-Phase beiderseits der dritten Bondmaterialschicht B22 auszubilden begonnen hat.

Optionalerweise kann eine weitere Erwärmung auf eine dritte Temperatur Td zu einem Zeitpunkt td vorgesehen werden, bei der sich eine feste, mechanisch stabile intermetallische Phase, hier Cu3Sn, ausbildet. Durch weiteres Halten der dritten Temperatur Td während einer vorbestimmten Zeitspanne kann die vollständige Bildung der mechanisch und thermodynamisch stabilen intermetallischen Phase Cu3Sn begünstigt werden, wonach dann ein Abkühlprozess stattfindet, um zum Zeitpunkt te einen erstarrten Bondverbindungsbereich BV aus der intermetallischen Verbindung zu erhalten.

Beiderseits des Bondverbindungsbereichs BV aus der intermetallischen Phase vorhanden sind Reste des modifizierten ersten Bondbereichs B1' und der zweiten Bondmaterialschicht B21 des zweiten Bondbereichs B2, der nun das Bezugszeichen B2' trägt, da die dritte Bondmaterialschicht B22 aus Zinn aufgezehrt ist.

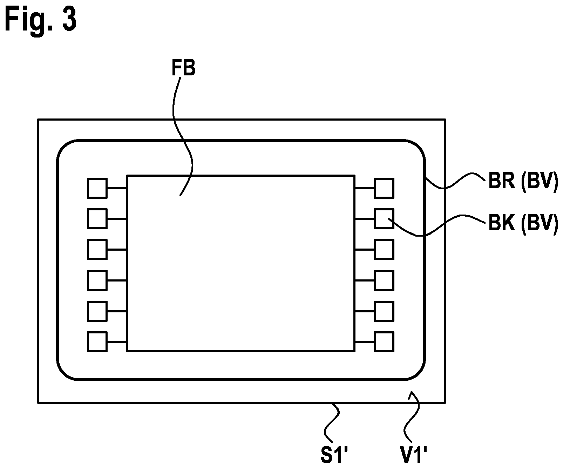

Fig. 3 zeigt eine schematische ebene Darstellung der Verbindungsebene eines MEMS-Substrats zur Verwendung beim beschriebenen Verfahren zum Verbinden zweier Substrate gemäß einer weiteren Ausführungsform der vorliegenden Erfindung.

Gemäß Fig. 3 ist ein MEMS-Wafersubstrat mit Bezugszeichen S1' bezeichnet, welches eine Vorderseite V1' aufweist. FB bezeichnet einen mikromechanischen Funktionsbereich, beispielsweise einen Drehratensensorbereich.

Bondkontakte BK sowie ein Bondrahmen BR sind vorgesehen, wobei die Bondkontakte BK eine elektrische Verbindung nach dem Bonden bilden sollen und der Bondrahmen einen hermetisch dichten Einschluss nach dem Bonden unter Ausbildung des Bondverbindungsbereichs BV bewirken soll.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt.

Als zweites Substrat zum Bonden eignet sich selbstverständlich neben dem Kappenwafersubstrat auch jegliches andere Substrat, beispielsweise ein ASIC-Substrat o. ä.

## Patentansprüche

1. Verfahren zum Verbinden zweier Substrate (S1; S2) mit den Schritten:
Bereitstellen eines ersten Substrats (S1) mit einer ersten Vorderseite (V1) und einer ersten Rückseite (R1) und eines zweiten Substrats (S2) mit einer zweiten Vorderseite (V2) und einer zweiten Rückseite (R2);
Aufbringen einer ersten Diffusionsbarriereschicht (D1) auf die erste Vorderseite (V1) und einer zweiten Diffusionsbarriereschicht (D2) auf die zweite Vorderseite (V2);
Aufbringen eines ersten Bondbereichs (B1) mit mindestens einer ersten Bondmaterialschicht (B1) auf die erste Diffusionsbarriereschicht (D1) und eines zweiten Bondbereichs (B2) mit mindestens einer zweiten Bondmaterialschicht (B21, B22) auf die zweite Diffusionsbarriereschicht (D2);
Aufbringen einer ersten Oxidationsschutzschicht (O1) mindestens auf den ersten Bondbereich (B1);
Aufheizen wenigstens des ersten Substrats (S1) im vom zweiten Substrat (S2) getrennten Zustand auf eine erste Temperatur (Tb), bei der die erste Oxidationsschutzschicht (O1) in den ersten Bondbereich (B1) zum Ausbilden eines modifizierten ersten Bondbereichs (B1') zumindest teilweise eindiffundiert;
anschließendes Zusammenbringen des ersten Substrats (1 a) und des zweiten Substrats (1 b), so dass sich der modifizierte erste Bondbereich (B1') und der zweite Bondbereich (B2) gegenüberliegen; und
Aufheizen des ersten und zweiten Substrats (S1; S2) im zusammengebrachten Zustand auf eine zweite Temperatur (Tc), bei der wenigstens eine Komponente des ersten oder zweiten Bondbereichs (B1; B2) aufschmilzt, und anschließendes Abkühlen zum Ausbilden eines Bondverbindungsbereichs (BV) zwischen dem ersten Substrat (S1) und dem zweiten Substrat (S2).

2. Verfahren nach Anspruch 1, wobei das zweite Substrat (S2) vor dem Zusammenbringen nasschemisch zur Oxidentfernung gereinigt wird.

3. Verfahren nach Anspruch 1 oder 2, wobei das erste und das zweite Substrat (S1; S2) gemeinsam, jedoch voneinander beabstandet in einem Bondtool auf die erste Temperatur (Tb) aufgeheizt werden.

4. Verfahren nach einem der vorhergehenden Ansprüche, wobei das Material der ersten Oxidationsschutzschicht (O1) einen Anteil unterhalb von 20 Atomprozent, bevorzugt unterhalb von 10 Atomprozent, gemittelt über den gesamten Bondverbindungsbereich (B1', B2', BV) aufweist.

5. Verfahren nach einem der vorhergehenden Ansprüche, wobei das Material der ersten oder zweiten Diffusionsbarrierenschicht (D1; D2) Titannitrid, Tantalnitrid oder Titan-Wolfram aufweist.

6. Verfahren nach einem der vorhergehenden Ansprüche, wobei das Material des ersten Bondbereichs (B1) Aluminium und des zweiten Bondbereichs (B2) Germanium oder Silizium ist.

7. Verfahren nach einem der Ansprüche 1 bis 5, wobei das Material des ersten Bondbereichs (B1) Kupfer und des zweiten Bondbereichs (B2) Kupfer-Zinn ist.

8. Verfahren nach einem der Ansprüche 1 bis 5, wobei das Material des ersten Bondbereichs (B1) Nickel und des zweiten Bondbereichs (B2) Nickel-Zinn ist.

9. Verfahren nach einem der vorhergehenden Ansprüche, wobei das Material der ersten Oxidationsschutzschicht (O1) Gold, Platin, Palladium, Ruthenium, Molybdän oder Wolfram aufweist.

10. Anordnung zweier Substrate (S1; S2) mit einem ersten Substrat (S1) mit einer ersten Vorderseite (V1) und einer ersten Rückseite (R1) und einem zweiten Substrat (S2) mit einer zweiten Vorderseite (V2) und einer zweiten Rückseite (R2)
**dadurch gekennzeichnet, dass** die Anordnung
• eine erste Diffusionsbarriereschicht (D1) auf der ersten Vorderseite (V1) und eine zweite Diffusionsbarriereschicht (D2) auf der zweiten Vorderseite (V2) aufweist,
• einen ersten Bondbereich (B1') mit mindestens einer ersten Bondmaterialschicht (B1') auf der ersten Diffusionsbarriereschicht (D1), in den ein Oxidationsschutzmaterial (O1) aus einem oxidationsresistenten Material zumindest teilweise eindiffundiert ist, und einem zweiten Bondbereich (B2') mit mindestens einer zweiten Bondmaterialschicht (B21) auf der zweiten Diffusionsbarriereschicht (D2) aufweist; und
• einen Bondverbindungsbereich (BV) zwischen dem ersten Bondbereich (B1') und dem zweiten Bondbereich (B2') aufweist.

11. Anordnung nach Anspruch 10, wobei das Oxidationsschutzmaterial einen Anteil unterhalb von 20 Atomprozent, bevorzugt unterhalb von 10 Atomprozent, gemittelt über den gesamten Bondverbindungsbereich (B1', B2', BV) aufweist.

12. Anordnung nach Anspruch 10 oder 11, wobei der Bondverbindungsbereich (BV) eine intermetallische Verbindung aufweist.

## Claims

1. Method of connecting two substrates (S1; S2), having the steps of:
- providing a first substrate (S1) with a first front side (V1) and a first rear side (R1) and a second substrate (S2) with a second front side (V2) and a second rear side (R2);
- depositing a first diffusion barrier layer (D1) onto the first front side (V1) and a second diffusion barrier layer (D2) onto the second front side (V2);
- depositing a first bond region (B1) with at least one first bond material layer (B1) onto the first diffusion barrier layer (D1) and a second bond region (B2) with at least one second bond material layer (B21, B22) onto the second diffusion barrier layer (D2);
- depositing a first oxidation protection layer (O1) at least onto the first bond region (B1);
- heating at least the first substrate (S1), while separate from the second substrate (S2), to a first temperature (Tb) at which the first oxidation protection layer (O1) at least partially diffuses into the first bond region (B1) to form a modified first bond region (B1');
- subsequently bringing together the first substrate (1a) and the second substrate (1b) such that the modified first bond region (B1') and the second bond region (B2) are opposite one another; and
- heating the first and second substrate (S1; S2), while brought together, to a second temperature (Tc) at which at least one component of the first or second bond region (B1; B2) melts, and subsequently cooling to form a bond connection region (BV) between the first substrate (S1) and the second substrate (S2).

2. Method according to Claim 1, wherein, before the two substrates are brought together, the second substrate (S2) is cleaned wet-chemically in order to remove oxides.

3. Method according to Claim 1 or 2, wherein the first and second substrates (S1; S2) are heated to the first temperature (Tb) together but at a distance from one another in a bond tool.

4. Method according to one of the preceding claims, wherein the material of the first oxidation protection layer (O1) has a fraction of below 20 atomic percent, preferably below 10 atomic percent, averaged over the entire bond connection region (B1', B2', BV).

5. Method according to one of the preceding claims, wherein the material of the first or second diffusion barrier layer (D1; D2) has titanium nitride, tantalum nitride or titanium-tungsten.

6. Method according to one of the preceding claims, wherein the material of the first bond region (B1) is aluminium and that of the second bond region (B2) is germanium or silicon.

7. Method according to one of Claims 1 to 5, wherein the material of the first bond region (B1) is copper and that of the second bond region (B2) is copper-tin.

8. Method according to one of Claims 1 to 5, wherein the material of the first bond region (B1) is nickel and that of the second bond region (B2) is nickel-tin.

9. Method according to one of the preceding claims, wherein the material of the first oxidation protection layer (O1) has gold, platinum, palladium, ruthenium, molybdenum or tungsten.

10. Assembly of two substrates (S1; S2), with a first substrate (S1) with a first front side (V1) and a first rear side (R1) and a second substrate (S2) with a second front side (V2) and a second rear side (R2)
**characterized in that** the assembly
- has a first diffusion barrier layer (D1) on the first front side (V1) and a second diffusion barrier layer (D2) on the second front side (V2),
- has a first bond region (B1') with at least one first bond material layer (B1') on the first diffusion barrier layer (D1), into which an oxidation protection material (O1) of an oxidation-resistant material is at least partially diffused, and a second bond region (B2') with at least one second bond material layer (B21) on the second diffusion barrier layer (D2), and
- has a bond connection region (BV) between the first bond region (B1') and the second bond region (B2').

11. Assembly according to Claim 10, wherein the oxidation protection material has a fraction of below 20 atomic percent, preferably below 10 atomic percent, averaged over the entire bond connection region (B1', B2', BV).

12. Assembly according to Claim 10 or 11, wherein the bond connection region (BV) has an intermetallic connection.

## Revendications

1. Procédé pour relier deux substrats (S1; S2), le procédé présentant les étapes suivantes :
préparer un premier substrat (S1) présentant une première face avant (V1) et une première face arrière (R1) et un deuxième substrat (S2) présentant une deuxième face avant (V2) et une deuxième face arrière (R2),
appliquer une première couche (D1) de barrière à la diffusion sur la première face avant (V1) et une deuxième couche (D2) de barrière à la diffusion sur la deuxième face avant (V2),
appliquer une première partie de liaison (B1) présentant au moins une première couche (B1) de matériau de liaison sur la première couche (D1) de barrière la diffusion et une deuxième partie de liaison (B2) présentant au moins une deuxième couche (B21, B22) de matériau de liaison sur la deuxième couche (D2) de barrière à la diffusion,
appliquer une première couche (O1) de protection contre l'oxydation au moins sur la première partie de liaison (B1),
chauffer au moins le premier substrat (S1) séparément du deuxième substrat (S2) à une première température (Tb) à laquelle la première couche (O1) de protection contre l'oxydation de la première partie de liaison (B1) diffuse au moins en partie pour former une première partie de liaison (B1') modifiée,
ensuite, assembler le premier substrat (1a) et le deuxième substrat (1b) de telle sorte que la première partie de liaison (B1') modifiée et la deuxième partie de liaison (B2) soient situées face à face et
chauffer le premier et le deuxième substrat (S1; S2) assemblés à une deuxième température (Tc) à laquelle au moins un composant de la première ou de la deuxième partie de liaison (B1; B2) fond, et ensuite refroidir pour former une partie (BV) de composé de liaison entre le premier substrat (S1) et le deuxième substrat (S2).

2. Procédé selon la revendication 1, dans lequel le premier substrat (S2) est nettoyé chimiquement en conditions humides avant l'assemblage, en vue d'éliminer les oxydes.

3. Procédé selon les revendications 1 ou 2, dans lequel le premier et le deuxième substrat (S1; S2) sont chauffés conjointement à la première température (Tb) et à distance l'un de l'autre dans un outil de liaison.

4. Procédé selon l'une des revendications précédentes, dans lequel le matériau de la première couche (O1) de protection contre l'oxydation présente une teneur inférieure à 20 pour cent atomiques et de préférence intérieure à 10 pour cent atomiques en moyenne sur la totalité de la zone de liaison (B1', B2', BV).

5. Procédé selon l'une des revendications précédentes, dans lequel le matériau de la première et de la deuxième couche (D1; D2) de barrière à la diffusion présente du nitrure de titane, du nitrure de tantale ou du titane-tungstène.

6. Procédé selon l'une des revendications précédentes, dans lequel le matériau de la première partie de liaison (B1) est l'aluminium et celui de la deuxième partie de liaison (B2) le germanium ou le silicium.

7. Procédé selon l'une des revendications 1 à 5, dans lequel le matériau de la première partie de liaison (B1) et le cuivre et celui de la deuxième partie de liaison (B2) du cuivre-étain.

8. Procédé selon l'une des revendications 1 à 5, dans lequel le matériau de la première partie de liaison (B1) est le nickel et celui de la deuxième partie de liaison (B2) du nickel-étain.

9. Procédé selon l'une des revendications précédentes, dans lequel le matériau de la première couche (O1) de protection contre l'oxydation présente de l'or, du platine, du palladium, du ruthénium, du molybdène ou du tungstène.

10. Ensemble constitué de deux substrats (S1; S2), avec un premier substrat (S1) présentant une première face avant (V1) et une première face arrière (R1) et un deuxième substrat (S2) qui présente une deuxième face avant (V2) et une deuxième face arrière (R2), **caractérisé en ce que** l'ensemble présente
une première couche (D1) de barrière à la diffusion sur la première face avant (V1) et une deuxième couche (D2) de barrière à la diffusion sur la deuxième face avant (V2),
une première partie de liaison (B1') qui présente au moins une première couche (B1') de matériau de liaison sur la première couche (D1) de barrière à la diffusion, et dans laquelle un matériau (O1) de protection contre l'oxydation constitué d'un matériau résistant à l'oxydation est diffusé au moins en partie et
une deuxième partie de liaison (B2') qui présente au moins une deuxième couche (B21) de matériau de liaison sur la deuxième couche (D2) de barrière à la diffusion et
une partie (BV) de composé de liaison entre la première partie de liaison (B1') et la deuxième partie de liaison (B2').

11. Ensemble selon la revendication 10, dans lequel le matériau de protection contre l'oxydation présente une teneur inférieure à 20 pour cent atomiques, de préférence inférieure à 10 pour cent atomiques, en moyenne sur la totalité de la partie de liaison (B1', B2', BV).

12. Ensemble selon les revendications 10 ou 11, dans lequel la partie (BV) de composé de liaison présente un composé intermétallique.
